# EUROPEAN PATENT APPLICATION

(11) **EP 4 780 169 A1**
(43) Date of publication of application: **22.07.2026**
(21) Application number: 25770916.2
(22) Date of filing: 26.05.2025
(51) Int. Cl.: H10F 19/85

(54) **CURVED PHOTOVOLTAIC TILE AND MANUFACTURING METHOD THEREFOR**

(30) Priority: 30.10.2024 CN 202411543525
(71) Applicant: Shenzhen Hello Tech Energy Co., Ltd, Shenzhen, Guangdong 518109 (CN)
(72) Inventor: GU, Hongyang, Shenzhen, Guangdong 518109 (CN); YU, Huajun, Shenzhen, Guangdong 518109 (CN); ZHU, Yanjun, Shenzhen, Guangdong 518109 (CN); WANG, Linqiang, Shenzhen, Guangdong 518109 (CN); HAN, Yingjie, Shenzhen, Guangdong 518109 (CN)
(74) Representative: advotec.
(86) International application number: PCT/CN2025/097193
(87) International publication number: WO 2026/091499

(57) **Abstract**

A curved photovoltaic tile (100) and a manufacturing method thereof. The method includes: cutting at least one complete solar cell (11) to obtain a plurality of flat solar cells (12); electrically connecting the plurality of flat solar cells (12) to form a flat solar cell unit (13); arranging the flat solar cell unit (13) on a flat backsheet (14) to obtain a flat assembly (10); shaping the flat assembly (10) to obtain a curved assembly (20); and stacking and fixing the curved assembly (20) and a curved panel (30) to obtain the curved photovoltaic tile (100), wherein the curved assembly (20) has a same shape as the curved panel (30).

## Description

### CROSS-REFERENCE TO RELATED APPLICATIONS

The present application claims priority and benefits of Patent Application No. 202411543525.X, filed with the China National Intellectual Property Administration on October 30, 2024, the content of which is incorporated herein by reference in its entirety.

### TECHNICAL FIELD

The present application relates to the field of photovoltaic technologies, and in particular to, a curved photovoltaic tile and a manufacturing method thereof.

### BACKGROUND

With the highlighting of severe problems such as energy shortage and climate emission, various countries in the world pay more and more attention to clean and pollution-free renewable energy sources. Solar energy is an inexhaustible green energy source. At present, the application fields of photovoltaic power generation are extensive, the design of building integrated photovoltaics (BIPV) gradually becomes a trend, and residential roofs are the main application areas of distributed photovoltaic power generation. A photovoltaic tile is usually formed by laminating tempered glass and solar cells, then assembling an aluminum frame for framing, and finally sealing edge portions with silicone. However, the inventors believe that when flat glass and flat solar cells are laminated to form a curved photovoltaic tile, microcracks easily occur in the solar cells, resulting in product failure.

### SUMMARY

The present application aims to solve at least one of the technical problems existing in the prior art or related art.

To this end, the present application provides a method for manufacturing a curved photovoltaic tile, including:
cutting at least one complete solar cell to obtain a plurality of flat solar cells;
electrically connecting the plurality of flat solar cells to form a flat solar cell unit;
arranging the flat solar cell unit on a flat backsheet to obtain a flat assembly;
shaping the flat assembly to obtain a curved assembly; and
stacking and fixing the curved assembly and a curved panel to obtain the curved photovoltaic tile, wherein the curved assembly has a same shape as the curved panel.

In this way, by cutting the complete solar cell, the resulting flat solar cells are smaller in size; and during the shaping of the flat assembly, the deformation of the flat solar cells on the curved panel can be reduced, thereby lowering the risk of microcracks in the flat solar cells. In addition, by shaping the flat assembly to obtain the curved assembly first, and then stacking and fixing the curved assembly with the curved panel, the pressure required for stacking and fixing the curved assembly with the curved panel to form the curved photovoltaic tile can be reduced, thereby reducing the phenomenon of microcracks in the flat solar cell unit and improving the production yield of the curved photovoltaic tile.

The present application proposes a curved photovoltaic tile, wherein the curved photovoltaic tile is manufactured by using the above-mentioned manufacturing method.

Additional aspects and advantages of the present application will be partly set forth in the following description, partly become apparent from the following description, or be learned through the practice of the present application.

### BRIEF DESCRIPTION OF DRAWINGS

The above-described and/or additional aspects and advantages of the present application will become apparent and readily understandable from the description of the embodiments in conjunction with the accompanying drawings below, in which:
FIG. 1 is a schematic structural diagram of a curved photovoltaic tile according to an embodiment of the present application;
FIG. 2 is a schematic exploded structural diagram of a curved photovoltaic tile according to an embodiment of the present application;
FIG. 3 is a schematic structural diagram of a curved photovoltaic tile according to an embodiment of the present application;
FIG. 4 is a schematic flowchart of a manufacturing method of a curved photovoltaic tile according to an embodiment of the present application;
FIG. 5 is a schematic diagram of a manufacturing process of a curved photovoltaic tile according to an embodiment of the present application;
FIG. 6 is a schematic structural diagram of a flat solar cell of a curved photovoltaic tile according to an embodiment of the present application;
FIG. 7 is a schematic structural diagram of a flat solar cell of a curved photovoltaic tile according to an embodiment of the present application; and
FIG. 8 is a schematic flowchart of a manufacturing method of a curved photovoltaic tile according to an embodiment of the present application.

Description of Reference Signs: 100, curved photovoltaic tile; 10. flat assembly; 11. complete solar cell; 12. flat solar cell; 13. flat solar cell unit; 14. flat backsheet; 15. first adhesive; 16. encapsulation layer; 20. curved assembly; 21. curved solar cell unit; 22. curved backsheet; 30. curved panel; 40. second adhesive.

### DESCRIPTION OF EMBODIMENTS

In order to more clearly understand the above objects, features and advantages of the present application, the present application is further described in detail below in conjunction with the accompanying drawings and specific embodiments. It should be noted that the examples of the present application and the features in the embodiments can be combined with each other, unless conflict occurs.

Many specific details are set forth in the following description to facilitate a full understanding of the present application, but the present application may also be implemented in other manners different from those described herein, and therefore, the protection scope of the present application is not limited by the specific embodiments disclosed below.

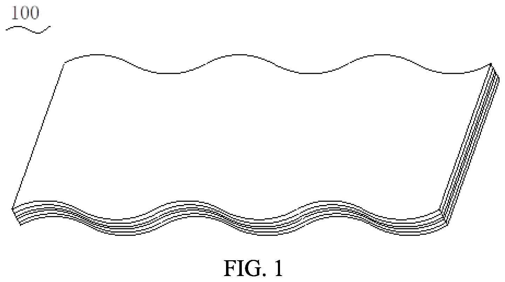

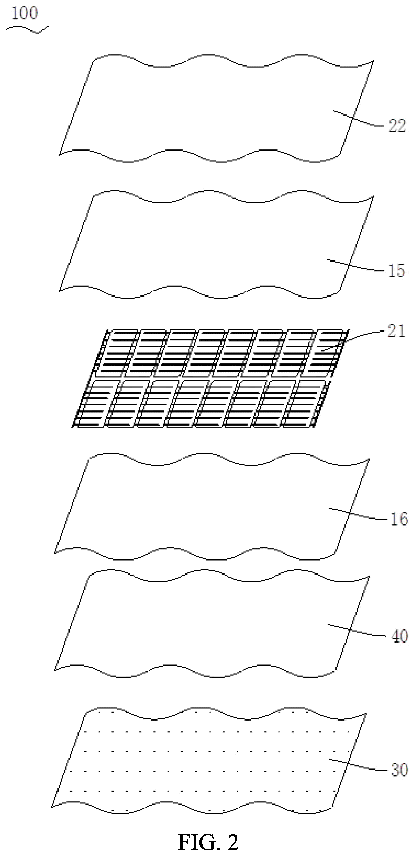

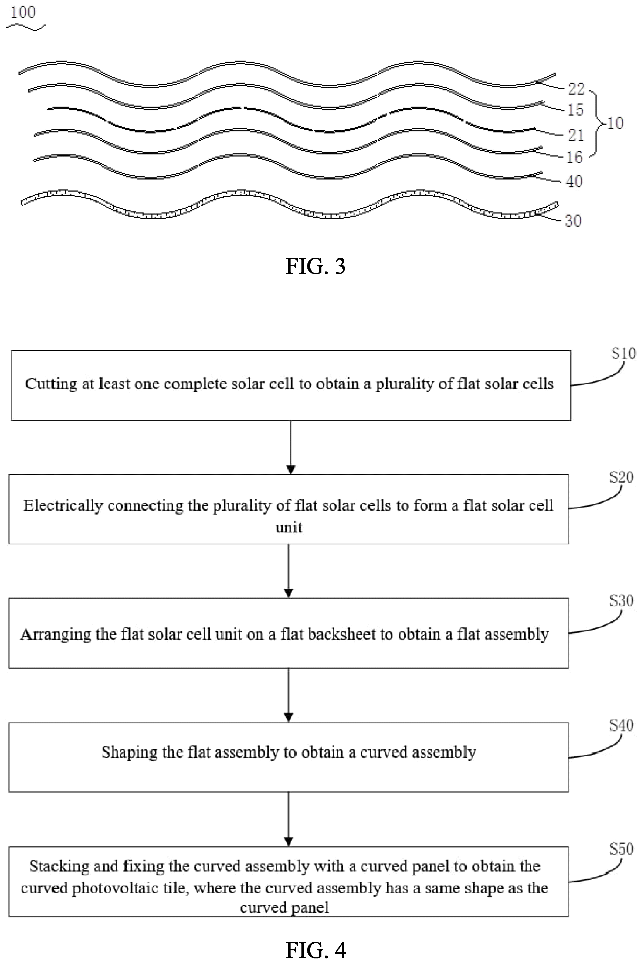

Referring to FIG. 1 to FIG. 5, a manufacturing method of a curved photovoltaic tile 100 according to an embodiment of the present application includes:
S10, cutting at least one complete solar cell 11 to obtain a plurality of flat solar cells 12;
S20, electrically connecting the plurality of flat solar cells 12 to form a flat solar cell unit 13;
S30, arranging the flat solar cell unit 13 on a flat backsheet 14 to obtain a flat assembly 10;
S40, shaping the flat assembly 10 to obtain a curved assembly 20; and
S50, stacking and fixing the curved assembly 20 with a curved panel 30 to obtain the curved photovoltaic tile 100, where the curved assembly 20 has a same shape as the curved panel 30.

In this way, by cutting the complete solar cell 11, the resulting flat solar cells 12 are smaller in size; and during the shaping of the flat assembly 10, the deformation of the flat solar cells 12 on the curved panel 30 can be reduced, thereby lowering the risk of microcracks in the flat solar cells 12. In addition, by obtaining the curved assembly 20 that has the same shape as the curved panel 30, and then stacking and fixing the curved assembly 20 with the curved panel 30, the pressure required for stacking and fixing the curved assembly 20 with the curved panel 30 to form the curved photovoltaic tile 100 can be reduced, thereby reducing the phenomenon of microcracks in the flat solar cell unit 13 and improving the production yield of the curved photovoltaic tile 100.

Specifically, the curved photovoltaic tile 100 is a type of roof tile capable of converting solar energy into electrical energy, and the curved photovoltaic tile 100 can not only be additionally installed on an existing roof surface, but also be used as a building member, that is, building integrated photovoltaic application. The curved photovoltaic tile 100 can be applied to flat or vertical installation.

The flat backsheet 14 can be made of a flexible polymer material, for example, PET, CPC, HPC, etc., so that the flat backsheet 14 can be bent into different shapes, and be suitable for different design requirements. After shaping the flat backsheet 14, a curved backsheet 22 can be obtained, and after shaping the flat solar cell unit 13, a curved solar cell unit 21 can be obtained.

The curved panel 30 and the curved backsheet 22 form an outermost layer of the curved photovoltaic tile 100, which can play a role of sealing, insulating and protecting the curved solar cell unit 21, thereby improving the mechanical performance of the curved photovoltaic tile 100. The curved panel 30 and the curved backsheet 22 can protect the curved solar cell unit 21 from damage caused by climate changes, for example, high temperature, low temperature, rain or hail, etc., and can also protect the curved solar cell unit 21 from damage caused by collisions and the like during transportation, which effectively improve the ability of the curved photovoltaic tile 100 to cope with harsh environments.

The curved panel 30 can be made of a light-transmitting material, for example, curved glass, and a light-transmitting curved panel 30 has good light transmittance. The curved panel 30 includes a light-receiving surface and a backlight surface, the curved panel 30 serves as a front surface of the curved photovoltaic tile 100, and sunlight can pass through the light-receiving surface of the curved panel 30 to irradiate the curved solar cell unit 21, facilitating the curved solar cell unit 21 to receive light and convert solar energy into electrical energy.

The shape of the curved assembly 20 is the same as the shape of the curved panel 30, for example, both the curved assembly 20 and the curved panel 30 are arched or wavy, and the undulation radian of their connecting surfaces is consistent.

The outer layer material of a back surface of the curved photovoltaic tile 100 is referred to as the curved backsheet 22, which is a key component of the curved photovoltaic tile 100, and the curved backsheet 22 isolates the curved solar cell unit 21 from the external environment to realize insulation, enabling the cell to operate outdoors for a long time. Curved backsheet 22 with different structures have different functions, and suitable curved backsheets 22 can be selected according to different use areas, for example, fluorine-containing backsheets can be used in areas with strong ultraviolet rays, white backsheets can enhance light reflection and improve power generation efficiency, black backsheets can meet the aesthetic requirements of roofs, and glass backsheets have higher light transmittance.

The complete solar cell 11 is preferably one of the cells among XBC, MWT, and shingled cells that have no metal grid lines and have both positive and negative metal electrodes led out from the back surface, and is secondarily preferably a solar cell with grid lines on both front and back surfaces, such as one of PERC and TOPCON. This can maintain the consistency of the appearance of the flat solar cell unit 13, and avoid metal grid lines and metal electrodes affecting the front appearance of the flat solar cell unit 13, thereby improving aesthetics.

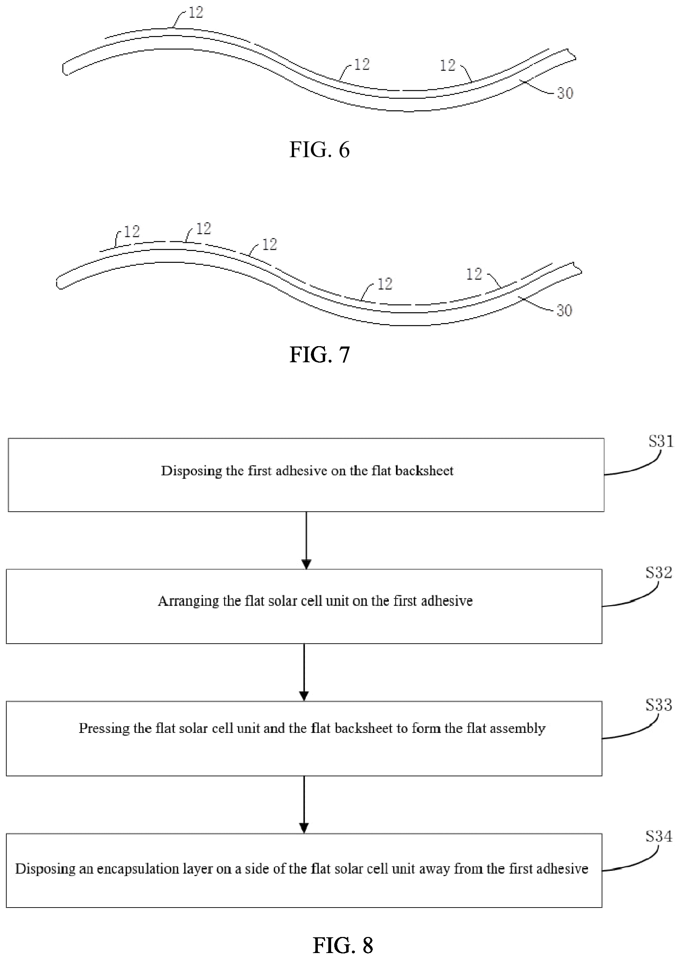

A laser cutting process can be used to cut one complete solar cell 11 into 2, 3, 4, 5 or more flat solar cells 12, and each solar cell 12 can be normally welded. In conjunction with FIG. 6 and FIG. 7, the flat solar cell 12 in FIG. 6 is 1/2 of a complete solar cell 11, and the flat solar cell 12 in FIG. 7 is 1/9 of a complete solar cell 11. The larger the number of the flat solar cells 12 obtained by cutting one complete solar cell 11, the smaller the size of each flat solar cell 12; and during the shaping of the flat assembly 10, the smaller the deformation of the flat solar cells 12 on the curved panel 30, and the lower the risk of microcracks in the flat solar cells 12.

The main role of the flat solar cell unit 13 is to generate electricity. The plurality of flat solar cells 12 can be sequentially arranged, and then the arranged flat solar cells 12 are electrically connected. The plurality of flat solar cells 12 can be arranged in a rectangular pattern. The flat solar cells 12 can be welded by using ribbons, a positive (or negative) electrode on the back surface of a previous flat solar cell 12 is connected to a negative (or positive) electrode on the front surface of a next flat solar cell 12, and they are heated to be welded together, and so on, to connect all the flat solar cells 12 in series. The flat solar cells 12 may be crystalline silicon solar cells, which have relatively lower equipment cost and relatively higher photoelectric conversion efficiency, and are suitable for generating electricity under outdoor sunlight.

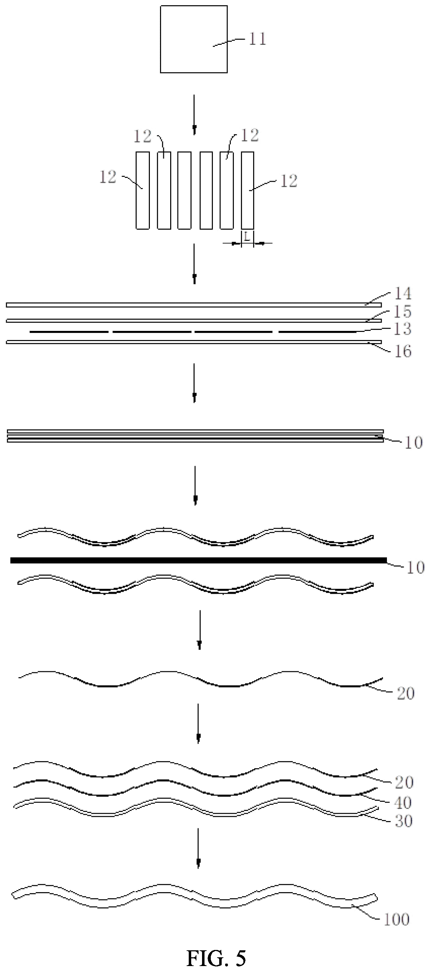

Referring to FIG. 5, in some embodiments, a width L of each of the flat solar cells 12 is 20 mm to 105 mm.

When the width L of each of the flat solar cells 12 is less than 20 mm, the difficulty of welding the flat solar cells 12 is high. When the width L of each of the flat solar cells 12 is greater than 105 mm, during the shaping of the flat assembly 10, the deformation of the flat solar cells 12 on the curved panel 30 is larger, thereby increasing the risk of microcracks in the flat solar cells 12. Therefore, when the width L of each of the flat solar cells 12 is within the aforesaid range, it is possible to reduce the size of the flat solar cells 12 while ensuring that the flat solar cells 12 can be normally welded.

Specifically, the width L of each of the flat solar cells 12 may refer to the length of each flat solar cell 12 along an arrangement direction of the plurality of flat solar cells 12. The width L of each of the flat solar cells 12 may be 20 mm, 35 mm, 40 mm, 55 mm, 60 mm, 75 mm, 90 mm, 105 mm, and the like. The width L of each flat solar cell 12 may be equal or unequal.

Referring to FIG. 5, in some embodiments, said arranging the flat solar cell unit 13 on a flat backsheet 14 to obtain a flat assembly 10 includes:
adhering the flat solar cell unit 13 onto the flat backsheet 14 through a first adhesive 15 to form the flat assembly 10.

In this way, the first adhesive 15 can bond the flat solar cell unit 13 and the flat backsheet 14 together, thereby improving the stability and reliability of the flat assembly 10.

Specifically, the first adhesive 15 may be an ethylene vinyl acetate (EVA) material, a thermoplastic polyolefin (TPO) material, a polyvinyl butyral (PVB) material, or a polyolefin elastomer (POE) material, to ensure encapsulation performance and light transmittance of the first adhesive 15, thereby ensuring power generation efficiency of the curved photovoltaic tile 100.

The first adhesive 15 may first be adhered onto the flat backsheet 14, and then the flat solar cell unit 13 may be adhered onto the first adhesive 15. Alternatively, the first adhesive 15 may first be adhered onto the flat solar cell unit 13, and then the flat backsheet 14 may be adhered onto the first adhesive 15.

Referring to FIG. 5 and FIG. 8, in some embodiments, said adhering the flat solar cell unit 13 onto the flat backsheet 14 through a first adhesive 15 to form the flat assembly 10 includes:
S31, disposing the first adhesive 15 on the flat backsheet 14;
S32, arranging the flat solar cell unit 13 on the first adhesive 15; and
S33, pressing the flat solar cell unit 13 and the flat backsheet 14 to form the flat assembly 10.

In this way, the flat solar cell unit 13 can be adhered onto the flat backsheet 14 by the above steps to form the flat assembly 10.

Specifically, a flat laminator can be used to press the flat solar cell unit 13 and the flat backsheet 14 to form the flat assembly 10. In one example, a vacuum environment can be created by evacuating through vacuum equipment; the flat backsheet 14, the first adhesive 15, and the flat solar cell unit 13 are placed in sequence; and the flat backsheet 14 can be pushed by the laminator. For example, the laminator can press the flat backsheet 14 down flatly toward the first adhesive 15 and the flat solar cell unit 13 through a flat silicone layer, thereby forming the flat assembly 10.

In some embodiments, said pressing the flat solar cell unit 13 and the flat backsheet 14 to form the flat assembly 10 includes:
pressing and fixing the flat solar cell unit 13 and the flat backsheet 14 by means of multi-stage pressing, where a pressing temperature of each stage increases stage by stage.

In this way, pressing and fixing the flat solar cell unit 13 and the flat backsheet 14 to form the flat assembly 10 by means of multi-stage pressing can improve the stability of the first adhesive 15, and facilitate the formation of a stable bond between the flat solar cell unit 13 and the flat backsheet 14, thereby improving the stability and reliability of the flat assembly 10.

The pressing temperature refers to the temperature applied by the laminator during the pressing process. In one embodiment, the pressing process for pressing the flat solar cell unit 13 and the flat backsheet 14 to form the flat assembly 10 is divided into four stages: a first stage has a pressing temperature of 80°C to 90°C and a pressing time of 5 min to 10 min; a second stage has a pressing temperature of 100°C to 110°C and a pressing time of 5 min to 10 min; a third stage has a pressing temperature of 120°C to 130°C and a pressing time of 5 min to 10 min; and a fourth stage has a pressing temperature of 150°C to 160°C and a pressing time of 40 min to 60 min.

Referring to FIG. 5 and FIG. 8, in some embodiments, said adhering the flat solar cell unit 13 onto the flat backsheet 14 through a first adhesive 15 to form the flat assembly 10 further includes:
S34, disposing an encapsulation layer 16 on a side of the flat solar cell unit 13 away from the first adhesive 15.

In this way, the encapsulation layer 16 can play a role of buffering during the shaping of the flat assembly 10, thereby lowering the risk of fragmentation of the flat solar cell unit 13.

Specifically, the material of the encapsulation layer 16 and the material of the first adhesive 15 may be the same or different. For example, both the encapsulation layer 16 and the first adhesive 15 are made of an EVA material. For another example, the encapsulation layer 16 is made of a TPO material, and the first adhesive 15 is made of a PVB material.

Referring to FIG. 5, in some embodiments, said shaping the flat assembly 10 to obtain a curved assembly 20 includes:
pressing the flat assembly 10 at a preset temperature using shaping tooling to obtain the curved assembly 20.

In this way, the flat assembly 10 is shaped by the shaping tooling, so that the curved assembly 20 obtained after shaping has the same as the curved panel 30.

Specifically, a surface shape of the shaping tooling can be designed according to a surface shape of the curved panel 30, and the pressure and temperature during shaping can be designed according to the degree of curvature of the curved panel 30 and the material of each component in the curved assembly 20.

Referring to FIG. 5, in some embodiments, said stacking and fixing the curved assembly 20 with a curved panel 30 includes:
stacking and disposing a second adhesive 40 and the curved panel 30 on a side of a curved solar cell unit 21 of the curved assembly 20 away from a curved backsheet 22, and pressing the curved assembly 20 and the curved panel 30.

In this way, the curved assembly 20 and the curved panel 30 can be connected through the second adhesive 40; furthermore, the second adhesive 40 can protect the side of the curved solar cell unit 21 away from the curved backsheet 22 from being in hard contact with the curved panel 30, thereby lowering the risk of microcracks in the curved solar cell unit 21.

In an example, a vacuum environment can be created by evacuating through vacuum equipment, and the laminator can form a mold having the same shape as the curved assembly 20 through mold opening to stably fix the curved assembly 20 and then to press and connect the curved panel 30 toward the second adhesive 40 and the curved assembly 20, thereby forming the curved photovoltaic tile 100.

In some embodiments, said pressing the curved assembly 20 and the curved panel 30 includes:
pressing and fixing the curved assembly 20 and the curved panel 30 by means of multi-stage pressing, where a pressing pressure of each stage increases stage by stage.

In this way, pressing and fixing the curved assembly 20 and the curved panel 30 to form the curved photovoltaic tile 100 by means of multi-stage pressing can increase an acting force between the curved assembly 20 and the curved panel 30, thereby improving the stability and the reliability of the curved photovoltaic tile 100.

In one embodiment, the pressing process of pressing and fixing the curved assembly 20 and the curved panel 30 is divided into three stages, a first stage has a pressing pressure of -80 kPa to -70 kPa and a pressing time of 30 s to 60 s; a second stage has a pressing pressure of -60 kPa to -50 kPa and a pressing time of 30 s to 60 s; and a third stage has a pressing pressure of -40 kPa to 0 kPa and a pressing time of 15 s to 20 s. The temperature for all three stages of pressing is 140°C to 150°C.

Referring to FIG. 5, the curved photovoltaic tile 100 according to an embodiment of the present application is manufactured by using the above manufacturing method, including:
S10, cutting at least one complete solar cell 11 to obtain a plurality of flat solar cells 12;
S20, electrically connecting the plurality of flat solar cells 12 to form a flat solar cell unit 13;
S30, arranging the flat solar cell unit 13 on a flat backsheet 14 to obtain a flat assembly 10;
S40, shaping the flat assembly 10 to obtain a curved assembly 20; and
S50, stacking and fixing the curved assembly 20 with a curved panel 30 to obtain the curved photovoltaic tile 100, where the curved assembly 20 has a same shape as the curved panel 30.

By cutting the complete solar cell 11 to obtain the plurality of flat solar cells 12, and then electrically connecting the plurality of flat solar cells 12 to form the flat solar cell unit 13, the flat solar cells 12 is smaller in size, and during the shaping of the flat assembly 10, the deformation of the flat solar cells 12 on the curved panel 30 can be reduced, thereby lowering the risk of microcracks in the flat solar cells 12. In addition, the primary pressing of the flat backsheet 14, the first adhesive 15, and the flat solar cell unit 13 is performed to form the flat assembly 10, then the flat assembly 10 is shaped to obtain the curved assembly 20 having the same shape as the curved panel 30, and finally the secondary pressing of the curved assembly 20 and the curved panel 30 is performed to form the curved photovoltaic tile 100. Since the shape of the flat solar cell unit 13 after shaping is the same as the shape of the curved panel 30, the pressure for the secondary pressing of the curved assembly 20 and the curved panel 30 can be reduced, thereby reducing the microcracks phenomenon of the curved solar cell unit 21 and improving the production yield of the curved photovoltaic tile 100.

In the description of this specification, descriptions made with references to terms such as "one embodiment", "certain embodiments", "exemplary embodiments", "examples", "specific examples", or "some examples" mean that the specific features, structures, materials, or characteristics described in connection with the embodiment or example are included in at least one embodiment or example of the present application. In this specification, the schematic representations of the above terms do not necessarily refer to the same embodiment or example. Moreover, the specific features, structures, materials, or characteristics described may be combined in any suitable manner in one or more embodiments or examples.

Although the embodiments of the present application have been shown and described, those of ordinary skill in the art can understand that various changes, modifications, substitutions, and variations may be made to these embodiments without departing from the principles and purposes of the present application, and the scope of the present application is defined by the claims and their equivalents.

## Claims

1. A method for manufacturing a curved photovoltaic tile, **characterized by** comprising:
cutting at least one complete solar cell to obtain a plurality of flat solar cells;
electrically connecting the plurality of flat solar cells to form a flat solar cell unit;
arranging the flat solar cell unit on a flat backsheet to obtain a flat assembly;
shaping the flat assembly to obtain a curved assembly; and
stacking and fixing the curved assembly and a curved panel to obtain the curved photovoltaic tile, wherein the curved assembly has a same shape as the curved panel.

2. The manufacturing method according to claim 1, **characterized in that** a width of each of the flat solar cells is 20 mm to 105 mm.

3. The manufacturing method according to claim 1, **characterized in that** said arranging the flat solar cell unit on a flat backsheet to obtain a flat assembly comprises:
adhering the flat solar cell unit onto the flat backsheet through a first adhesive to form the flat assembly.

4. The manufacturing method according to claim 3, **characterized in that** said adhering the flat solar cell unit onto the flat backsheet through a first adhesive to form the flat assembly comprises:
disposing the first adhesive on the flat backsheet;
arranging the flat solar cell unit on the first adhesive; and
pressing the flat solar cell unit and the flat backsheet to form the flat assembly.

5. The manufacturing method according to claim 4, **characterized in that** said pressing the flat solar cell unit and the flat backsheet to form the flat assembly comprises:
pressing and fixing the flat solar cell unit and the flat backsheet by means of multi-stage pressing, wherein a pressing temperature increases stage by stage.

6. The manufacturing method according to claim 5, **characterized in that** a pressing temperature for pressing and fixing the flat solar cell unit and the flat backsheet is 80°C to 160°C.

7. The manufacturing method according to claim 5, **characterized in that** a pressing time for pressing and fixing the flat solar cell unit and the flat backsheet is 5 min to 60 min.

8. The manufacturing method according to claim 3, **characterized in that** said adhering the flat solar cell unit onto the flat backsheet through a first adhesive to form the flat assembly further comprises:
disposing an encapsulation layer on a side of the flat solar cell unit away from the first adhesive.

9. The manufacturing method according to claim 1, **characterized in that** said shaping the flat assembly to obtain a curved assembly comprises:
pressing the flat assembly at a preset temperature using shaping tooling to obtain the curved assembly.

10. The manufacturing method according to claim 1, **characterized in that** said stacking and fixing the curved assembly and a curved panel to obtain the curved photovoltaic tile comprises:
stacking and disposing a second adhesive and the curved panel on a side of a curved solar cell unit of the curved assembly away from a curved backsheet, and pressing the curved assembly and the curved panel.

11. The manufacturing method according to claim 10, **characterized in that** said pressing the curved assembly and the curved panel comprises:
pressing and fixing the curved assembly and the curved panel by means of multi-stage pressing, wherein a pressing pressure increases stage by stage.

12. The manufacturing method according to claim 1, **characterized in that** a pressing pressure for pressing and fixing the curved assembly and the curved panel is -80 kPa to 0 kPa.

13. The manufacturing method according to claim 1, **characterized in that** a pressing time for pressing and fixing the curved assembly and the curved panel is 15 s to 60 s.

14. The manufacturing method according to any one of claims 1 to 13, **characterized in that** the flat backsheet is made of a flexible polymer material.

15. The manufacturing method according to any one of claims 1 to 14, **characterized in that** the curved panel is made of a light-transmitting material.

16. The manufacturing method according to any one of claims 1 to 15, **characterized in that** the flat solar cells are crystalline silicon solar cells.

17. A curved photovoltaic tile, **characterized in that** the curved photovoltaic tile is manufactured by using the manufacturing method according to any one of claims 1 to 16.

18. The curved photovoltaic tile according to claim 17, **characterized in that** the flat backsheet is made of a flexible polymer material.

19. The curved photovoltaic tile according to claim 17 or 18, **characterized in that** the curved panel is made of a light-transmitting material.

20. The curved photovoltaic tile according to any one of claims 17 to 19, **characterized in that** the flat solar cells are crystalline silicon solar cells.
